Europäisches Patentamt

European Patent Office

Office européen des brevets

(11) Publication number: **0 259 812**
**A2**

# EUROPEAN PATENT APPLICATION

(21) Application number: 87113013.4

(22) Date of filing: 05.09.87

(51) Int. Cl.⁴: **G03F 7/10** , G03C 1/68

(30) Priority: 10.09.86 US 905542

(43) Date of publication of application:
16.03.88 Bulletin 88/11

(84) Designated Contracting States:
BE CH DE FR GB IT LI NL SE

(71) Applicant: E.I. DU PONT DE NEMOURS AND
COMPANY
1007 Market Street
Wilmington Delaware 19898(US)

(72) Inventor: Tecle, Berhan
913-D Cloister Road
Wilmington Delaware 19809(US)

(74) Representative: Werner, Hans-Karsten, Dr. et
al
Deichmannhaus am Hauptbahnhof
D-5000 Köln 1(DE)

(54) Photopolymerizable compositions containing inorganic fillers.

(57) Improved performance in photopolymerizable compositions has been obtained by mixing inorganic filler with polymeric binder prior to incorporation of monomer.

EP 0 259 812 A2

## PHOTOPOLYMERIZABLE COMPOSITIONS CONTAINING INORGANIC FILLERS

### BACKGROUND OF THE INVENTION

The present invention is directed to improved photopolymerizable compositions which contain inorganic particulate material, processes of formulating such compositions and methods of use. The photopolymerizable compositions have been found to possess improved properties due to the manner of incorporation of the inorganic particulate material into the photopolymerizable compositions.

The use of particulates such as organic or inorganic fillers in photopolymerizable compositions is well known in the prior art. U.S. Patent 2,760,863 teaches photopolymerizable layers which contain addition polymerizable monomer, photopolymerization initiator or catalyst, preformed condensation or addition polymer and immiscible organic or inorganic fillers or reinforcing agents which are essentially transparent e.g., organophilic silica, bentonite, silica and powdered glass having a particle size less than 0.4 mil. U.S. Patent 3,525,615 discloses image forming polymerizable compositions containing inorganic thixotropic material which is preferably colloidal thixotropic metallic oxide which carry a surface charge and range in size from 5 to 500 millimicrons. Examples of such material includes boehmite alumina, clay mixtures of highly thixotropic silicate oxide such as bentonite and finely divided thixotropic gel containing 99.5% silica with 0.5% mixed metallic oxide. U.S. Patent 3,615,448 discloses lithographic printing plates containing a layer of a photocurable composition with finely divided particles of a vinyl plastic. The layer is imagewise exposed to UV radiation and is uniformly heat fluxed whereby the photocurable composition plasticizes the vinyl particles in nonexposed image areas. U.S. Patent 3,754,920 relates to photopolymerizable elements for reproducing images which contain a particulate microcrystalline thickener in a photopolymerizable layer. The thickener may be organic or inorganic with examples of organic thickeners including microcrystalline cellulose and examples of inorganic thickeners including particulate microcrystalline silicas, clays, alumina, bentonite, kaolinites, attapulgites and montmorillonites. U.S. Patent 3,891,441 is directed to a light sensitive printing material with a porous support impregnated with a photopolymerizable composition which contains a filler which is a finely divided powder having a particle size of 5 millimicrons to 50 microns. Named fillers include silicon oxide, titanium oxide, carbon black, zinc oxide and other commercially available pigments.

### SUMMARY OF THE INVENTION

The present invention is directed to a photopolymerizable composition comprising

(A) an addition polymerizable ethylenically unsaturated monomer.

(B) an initiating system activated by actinic radiation.

(C) at least one preformed macromolecular polymeric binder and

(D) particles of an inorganic material substantially transparent to actinic radiation wherein the particles of inorganic material are associated with at least one of the preformed macromolecular polymeric binders which association is determined by the inability of the inorganic particles to substantially separate from at least one of the binders in a solvent for the binder. Preferably substantially all of the particles are associated as determined by the inability to separate in a solvent for the binder.

The present invention is also directed to a process of formulating a photopolymerizable composition by mixing the inorganic particles with a binder in a separate step which excludes introduction of any component of the photopolymerizable composition which would interfere with the association with the inorganic particles and a binder as measured by substantially no separation of the particles from the binder in an organic solvent for the binder.

### DETAILED DESCRIPTION OF THE INVENTION

The starting materials of the present photopolymerizable composition of an addition polymerizable ethylenically unsaturated monomer, an initiating system activated by actinic radiation and at least one preformed macromolecular polymeric binder are well known in the prior art. The critical feature of the present invention is the inclusion of a defined particulate filler material and the manner it is associated with the binder in the composition. Although filler materials have been taught in a number of prior art publications, improved results have been found in the filler materials as defined herein and its association with the polymeric binder of the photopolymerizable composition. It has been found that the manner of introduction of the filler in the photosensitive composition leads to different properties in comparison to introduction of filler particles in a different way.

The particulate material incorporated in the photopolymerizable composition is inorganic and substantially transparent to actinic radiation. Although a silica or silicate derivative is preferred, generally inorganic materials which are transparent to actinic radiation can be employed such as an alumina or carbonate derivative. Preferably these particles can pass UV light without substantial absorption since otherwise the particles will interfere with conventional imaging of many photosensitive films. Generally, particles have a particle size distribution in the range from 0.1 $\mu$m to 15 $\mu$m and more preferably in the range of 0.1 $\mu$m to 10 $\mu$m wherein at least 95% and more generally 97% of the particles are in this size distribution. Measurement techniques for particles are well known, e.g., employment of a Coulter Counter. Generally the particles will be spherical, i.e., nonfibrous. Particles which are unduly small will lead to greater difficulty for rheological control and reduced reinforcement while particles which are unduly large can lead to reduced coating quality and imaging properties. Generally the particles will have a dielectric content in the range from 3.8 to 6.14.

In the photopolymerizable composition of the present invention it is necessary that the filler particles are associated with the polymeric binder. The association of the filler particles with the binder is characterized by an irreversible adsorption of the binder on the filler as shown by a complete failure to separate the filler and the binder by a solvent system. Association means the inability of filler particles to separate from polymer binder in solvent for the binder. If proper association is not present between the filler particles and polymeric binder the polymeric binder will dissolve in the solvent but the filler particles will separate and form a sediment, which is free of binder.

Without being bound to any theory or any mode of operation, it is considered that the polymeric binder has active sites which allow an interaction between the binder and the filler particles which is sufficient to resist separation of these two materials in solvent for the binder. If another component of the photopolymerizable composition is present with the binder prior to and during the mixing with the particulate material, interference is believed to conventionally occur in interaction since a foreign substrate will prevent some of the particulate material from approaching the active sites of the binder. With an increasing amount of interfering material or an increasing ability of an additional component to interact with these active sites, it is believed that fewer active sites interact and form an association of the binder and filler.

As support for this theory, it has been possible to separate substantially all of the filler particles from the binder from a photopolymerizable composition wherein all components have been simultaneously mixed by addition of a solvent for the binder. With a properly associated particulate filler with the polymeric binder, filler particles do not significantly separate from the binder. Generally a substantial amount of the particles remain associated with the binder. An alternate test is possible for measurement namely the particles generally do not separate from the binder in a solvent (or solvent system) for the binder in comparison to an identical polymerizable composition which is formed when components are mixed simultaneously.

To obtain the necessary association it is essential that the filler can interact with the binder such that it does not separate in solvent. Solvent as employed herein also refers to a combination of solvents to form a solvent system. It may be desirable to surface modify the filler. Techniques known in the prior art to increase activity of a surface can be utilized herein, e.g., surface treatment with silane coupling agents, stearate coatings, etc.

To obtain proper association the sequence of mixing of the components of the photopolymerizable composition is important. Mixing of all components simultaneously is unsatisfactory since the necessary degree of association as defined herein will not take place and a substantial number of filler particles can be separated from the polymeric binder in solvent.

A simple screening test can be utilized to determine whether a third substance can be present in the mixing step of the particulates and binder and whether the particulate has sufficient surface activity to bring about the necessary association. Initially the particulate filler and polymeric binder are premixed and added to solvent for the binder. If the filler separates from the binder to a significant degree particularly in the preferred mode wherein substantially none of the particles separate from the binder, the filler preferably is surface treated to increase its surface wettability for increased association. In the screening test conventionally the particulate filler will have particles so large that with or without association with the binder, they will settle from the solvent. In such event it is necessary to determine the chemical makeup of the filler. If the particles are not chemically bound to the binder the proper association has not taken place. Only fine particulates are present which allow the particles to remain suspended in the solvent due to Brownian movement. It is necessary to separate the particles from solvent such that chemical testing can be undertaken to determine the presence of binder with the particles.

Although mixing of particulate filler and polymeric binder alone is preferred, other components may be tolerated provided they do not interfere with the association. Illustratively the polymerizable composition conventionally contains various additives such as dyes, stabilizers, etc. and it may be possible to include these materials in this mixing step. Since monomer is present as a substantial portion of the photopolymerizable composition, it will interfere with the degree of association if added with mixing of the filler and binder and such monomer should be introduced in a separate mixing step.

If a mixture of polymeric binders is employed in the photopolymerizable composition it cannot be assumed that the filler particles can be directly mixed with all of the binder. In fact it has been discovered that it may be essential that the mixing not include all binders since the optimum degree of association will not take place. Since each of the binders will have active sites, the binders can interact and decrease the number of active sites available for association.

The mixing of the particular filler and binder can be by conventional techniques which obtain uniformity in the blending operation. A preferred mixing operation is by sand or ball milling. Even more preferred is melt blending and high shear dispersion in a two roll mill (such as at a temperature in the range from 110°C to 150°C). The resulting composite can be ground and used as solid ingredient in the solution mix. Thereafter the remaining components can be added to form the photopolymerizable composition in accordance with conventional techniques.

The use of particulate material in a photopolymerizable composition can result in an increased ability of the composition to adhere to a substrate, faster photospeed and better flame retardance. An additional advantage due to the manner of incorporation of the filler as described above is an increased ability of the exposed and cured composition to withstand thermal shock. Solder mask films formulated from photosensitive dry film conventionally have not been able to pass rigid specifications or have been marginally successful. Formulations of the present invention have been found to meet and exceed rigid test requirements.

As previously discussed the photosensitive formulation will contain a preformed polymeric binder. Suitable binders which can be used alone, if employed, or in combination with one another include the following: polyacrylate and alpha-alkyl polyacrylate esters, e.g., polymethyl methacrylate and polyethyl methacrylate; polyvinyl esters, e.g., polyvinyl acetate, polyvinyl acetate/acrylate, polyvinyl acetate/methacrylate and hydrolyzed polyvinyl acetate; ethylene/vinyl acetate copolymers; polystyrene polymers and copolymers, e.g., with maleic anhydride and esters; vinylidene chloride copolymers, e.g., vinylidene chloride/acrylonitrile; vinylidene chloride/methacrylate and vinylidene chloride/vinyl acetate copolymers; polyvinyl chloride and copolymers, e.g., polyvinyl chloride/acetate; saturated and unsaturated polyurethanes; synthetic rubbers, e.g., butadiene/acrylonitrile, acrylonitrile/butadiene/styrene, methacrylate/acrylonitrile/butadiene/styrene copolymers, 2-chloro-butadiene-1,3 polymers, chlorinated rubber, and styrene/butadiene/styrene, styrene/isoprene/styrene block copolymers; high molecular weight polyethylene oxides of polyglycols having average molecular weights from about 4,000 to 1,000,000; epoxides, e.g., epoxides containing acrylate or methacrylate groups; copolyesters, e.g., those prepared from the reaction product of a polymethylene glycol of the formula $HO(CH_2)_nOH$, where n is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylons or polyamides, e.g., N-methoxy-methyl polyhexamethylene adipamide; cellulose esters, e.g., cellulose acetate, cellulose acetate succinate and cellulose acetate butyrate; cellulose ethers, e.g., methyl cellulose, ethyl cellulose and benzyl cellulose; polycarbonates; polyvinyl acetal, e.g., polyvinyl butyral, polyvinyl formal; polyformaldehydes.

In the case where aqueous development (in comparison to solvent development) of the photosensitive composition is desirable the binder should contain sufficient acidic or other groups to render the composition processible in aqueous developer. Useful aqueous-processible binders include those disclosed in U.S. Patent 3,458,311 and in U.S. Patent 4,273,857. Useful amphoteric polymers which are aqueous processible include interpolymers derived from N-alkylacrylamides or methacrylamides, acidic film-forming comonomer and an alkyl or hydroxyalkyl acrylate such as those disclosed in U.S. Patent 4,293,635. In development the photosensitive layer will be removed in portions which are not exposed to radiation but will be substantially unaffected during development by a liquid such as wholly aqueous solutions containing 1% sodium carbonate by weight. Illustratively a liquid or solution at a temperature of 40°C during a time period of five minutes will remove areas of the composition which have not been exposed to actinic radiation but will not remove exposed areas.

Suitable monomers which can be used as the sole monomer or in combination with others include the following: t-butyl acrylate, 1,5-pentanediol diacrylate, N,N-diethylaminoethyl acrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent 3,380,831, 2,2-di-(p-hydroxyphenyl)-propane diacrylate, pentaerythritol tetraacrylate, 2,2-di-(p-hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphenolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzene, and 1,3,5-triisopropenyl benzene.

A class of monomers are an alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages particularly when present as terminal linkages. Especially preferred are those wherein at least one and preferably most of such linkages are conjugated with a double bonded carbon, including carbon double bonded to carbon and to such heteroatoms as nitrogen, oxygen and sulfur. Outstanding are such materials wherein the ethylenically unsaturated groups, especially the vinylidene groups, are conjugated with ester or amide structures.

Preferred free radical-generating addition polymerization initiators activatable by actinic light and thermally inactive at and below 185°C include the substituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2,3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetrahydrobenz(a)-anthracene-7,12-dione. Other photoinitiators which are also useful, even though some may be thermally active at temperatures as low as 85°C, are described in U.S. Patent 2,760,863 and include vicinal ketaldonyl alcohols, such as benzoin, pivaloin, acryloin ethers, e.g., benzoin methyl and ethyl ethers; α-hydrocarbon-substituted aromatic acyloins, including α-methylbenzoin, α-allylbenzoin and α-phenylbenzoin. Photoreducible dyes and reducing agents disclosed in U.S. Patents: 2,850,445; 2,875,047; 3,097,096; 3,074,974; 3,097,097; and 3,145,104 as well as dyes of the phenazine, oxazine, and quinone classes; Michler's ketone, benzophenone, 2,4,5-triphenylimidazolyl dimers with hydrogen donors, and mixtures thereof as described in U.S. Patents: 3,427,161; 3,479,185; and 3,549,367 can be used as initiators. Similarly the cyclohexadienone compounds of U.S. Patent No. 4,341,860 are useful as initiators. Also useful with photoinitiators and photoinhibitors are sensitizers disclosed in U.S. Patent 4,162,162.

Thermal polymerization inhibitors that can be used in the photopolymerizable compositions are: p-methoxyphenol, hydroquinone, and alkyl and aryl-substituted hydroquinones and quinones, tert-butyl catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-toluquinone and chloranil. Also useful for thermal polymerization inhibitors are the nitroso compositions disclosed in U.S. 4,168,982.

Various dyes and pigments may be added to increase the visibility of the resist image. Any colorant used, however, should preferably be transparent to the actinic radiation used.

On the basis of monomer, initiating system and binder, these components will conventionally be present in an amount of weight of 20 to 40 parts monomer, 0.01 to 10.0 parts initiating system and 10 to 90 parts binder. More generally will be present 25 to 35 parts monomer, 4.0 to 8.0 parts initiating system and 40 to 70 parts binder. Typically the particles will be present in an amount from 10 to 45 parts by weight and more preferred 25 to 35 parts. Lower and higher ratios can be employed provided the results disclosed herein are obtained

In use the photosensitive composition for application to a substrate such as in making a printed circuit board is conventionally supported by a film which is well known in the art. A suitable support preferably having a high degree of dimensional stability to temperature changes may be chosen from a wide variety of films composed of high polymers, e.g., polyamides, polyolefins, polyesters, vinyl polymers, and cellulose esters. A preferred support for the present invention is polyethylene terephthalate. Also generally a cover sheet is present in the opposite side of the photosensitive composition which is not present as a liquid. The protective cover sheet which has less adhesion in formation of the final article than the support is removed prior to lamination of the photosensitive composition to a substrate. The cover sheet may be chosen from the same group of polymer films listed as supports. Polyethylene and polyethylene terephthalate are particularly useful.

A preferred use of compositions characterized herein is as a photoresist or a solder mask such as in making a printed circuit board. Such techniques are conventional in the art employing a solid material, e.g., U.S. Patent 3,469,982. The process is directed to laminating a photosensitive layer to a substrate comprising:

(a) laminating to the substrate a supported layer of photosensitive film,

(b) imagewise exposing the layer to actinic radiation,

(c) removing unexposed areas of the layer to form resist areas,

(d) permanently modifying areas of the substrate which are unprotected by the resist areas by etching the substrate or by depositing a material onto the substrate.

The support is conventionally removed before or after the exposure step. In the case of solder mask utility the step of depositing a material can be by application of molten solder. In a utility not involving direct use as a solder mask in initial application to a substrate (which is conductive with copper preferred) the resist areas are removed after step (d) which is conventional.

The following examples serve to illustrate, the practice of the present invention. All percentages, ratios and parts are by weight unless otherwise indicated.

## EXAMPLE 1

## CONTROL I

The incorporation of fillers in photoimageable solder mask composition was investigated. The filler types in this study were carefully chosen not to interfere with the imaging, optical and performance properties of the solder mask. Chemical composition criteria was used to group them into four classes. They include silica, silicates, alumina and carbonates. The following compositions were found to have several improved properties from the incorporation of fillers.

A. Aqueous Processible Composition

a) 10.48 parts of pentaerythritol triacrylate, a tri-functional acrylate monomer

b) 10.48 parts of trimethylolpropane triacrylate, a trifunctional acrylate monomer

c) 8.76 parts of hexamethoxymethylmelamine, a melamine thermal crosslinking agent

d) 2.80 parts of benzophenone

e) 0.08 parts of Michler's ketone

f) 0.04 parts of diethylhydroxylamine

g) 0.12 parts of 3-mercapto-1,2,4-triazole

h) 2.12 parts of HVT-45 green pigment

i) 29.52 parts of Carboset®525 (methylmethacrylate/ethylacrylate/-acrylic acid) polymer binder

j) 1.40 parts of Amphomer® amphoteric pentapolymer (tert-octyl-acrylamide/methylmethacrylate/-hydroxypropyl-methacrylate/tertbutylaminoethylmethacrylate/acrylic acid) acrylic binder

k) 4.20 parts of PVP K-90 (polyvinylpyrrolidone)

l) 30.00 parts of fillers. Seven fillers representing different classes, mineral processing conditions and surface treatment were used in the composition.

i) Mistron Ultramix, a magnesium silicate (talc) having platey particles ranging 1.5-10 $\mu$m.

ii) Mistron Cyprubond, a magnesium silicate (talc) having the same particle shape as Mistron Ultramix. The particle size is 1.5-20 $\mu$m. It is also surface treated with an aminosilane coupling agent to improve polymer wettability.

iii) 5965 Super Flex 200, precipitated calcium carbonate with spherical particle shape and surface treated with stearic acid. The mean particle size is 5 $\mu$m.

iv) Harwick #71T, aluminum silicate (clay) with platey particles having a mean particle size of 0.55 $\mu$m. Processing was done by ultraflotation wet process. This clay was also surface treated with $\gamma$-methacryloxypropyltrimethoxy silane coupling agent in situ.

v) Huber HG-90®, aluminum silicate (clay) made by wet process and calcined had mean particle size of 0.2 $\mu$m. The particle shapes are platey.

vi) L-207A Novacite® particles, particle size range 0.5 to 15 $\mu$m. The shape of the particle are platelets and clusters. It is a naturally occurring silica.

vii) IMSIL® A-108-S, similar to L-207A Novacite but from different mineral origin. Particle size range from 0.4 to 10 $\mu$m. Surface treated with $\gamma$-mercaptopropyltrimethoxysilane.

The above formulation was made in 92/8 $CH_2Cl_2/CH_3OH$ coating solvent at 25% solids. After all the organic ingredients were dissolved the filler was added and dispersed by ball milling. Improved photospeed, solvent resistance, solderability, creep viscosity and thermal shock was observed compared to a formulation without the filler. The data is summarized in Table I.

7

## TABLE 1

| # | FILLER | Photospeed[a] $(mJ/cm^2 \, SST)$ | TTC[b] (SEC) | Solder[c] Dip | Solvent[d] Resistance (> 8 min) |
|---|---|---|---|---|---|
| 1 | Control | 225/8 | 85 | + | + |
| 2 | Mistron Ultramix | 75/6 | 70 | + | + |
| 3 | Mistron Cyprubond | 50/7 | 70 | + | + |
| 4 | 5965 Super Pflex 200 | 75/6 | 79 | + | + |
| 5 | Harwick #71T | 75/5 | 64 | + | + |
| 6 | Huber HG-90® | 75/5 | 82 | + | + |
| 7 | L-207A Novacite | 100/7 | 70 | + | + |
| 8 | IMSIL® A-108-S | 100/6 | 78 | + | + |

### TABLE 1 (continued)

| # | FILLER | Creep[e] viscosity $(10^6 \, poise)$ | M&IR[f] $(10^9)$ | Thermal[g] Shock | Flammability[h] On 0.062" | On 0.031" |
|---|---|---|---|---|---|---|
| 1 | Control | 37.1 | 2.00 | − | V−O | No rating |
| 2 | Mistron Ultramix | 246.0 | 0.45 | + | V−O | − |
| 3 | Mistron Cyprubond | 119.8 | 0.80 | + | V−O | V−O |
| 4 | 5965 Super Pflex 200 | 101.3 | 0.30 | − | V−O | − |
| 5 | Harwick #71T | 107.0 | 0.55 | − | V−O | − |
| 6 | Huber HG-90® | 162.6 | 0.45 | − | V−O | − |
| 7 | L-207A Novacite | 74.8 | 0.75 | − | V−O | − |
| 8 | IMSIL® A-108-S | 105.7 | 1.00 | − | V−O | − |

Footnotes to Table 1

a) Photospeed of solder mask coatings were determined by the amount of UV energy required and the last step held in the Stouffer Step Tablet, which gave optimum (line = space) resolution in a Stouffer Coverging Wedge. The coatings were laminated on copper clad glass epoxy panels.

b) Time to clear is the amount of time required to completely wash off the unexposed resist from a copper panel. This time is doubled to determine the time required for development.

c) Solderability test which required a 5 sec dip in a solder pot at 500°F, then fluxing the test panels with Alpha 709 flux and dipping into the solder for another 5 sec. Panels which survived this test without blistering were considered to pass solderability test.

d) A minimum of 8 min was required for cured boards to pass solvent resistance. The boards were dipped in a CH₂Cl₂ solvent and if there is no attack by the solvent for at least 8 min the solder mask was considered to have good resistance to aggressive solvents.

e) Creep viscosity was determined on a Du Pont 943 TMA unit with 1090 Thermal Analysis System. These films (3 mil) were successively laminated on a 4 mil Cronar® film to make a 36 mil thick film. Samples were prepared from this film for analysis.

f) Moisture and Insulation Resistance Test was done as specified on IPC-SM-840A to meet class III condition. The test calls for 7 day test at 90% RH and 25°± 2°C to 65° ± 2°C.

g) Thermal Shock was done at -65°C to 125°C for 100 cycles according to Mil Spec 55-110C. Boards were examined for cracks or blisters at 3X and 10X magnification.

+ means pass

-means fail

h) Flammability test was done according to UL-94 procedure for V-O rating.

B. Solvent Processible Composition

a) 15.75 parts of Celrad®3700, a diacrylated ester of bisphenol-A type of epoxy resin

b) 19.25 parts of pentaerythritol triacrylate monomer

c) 17.77 parts of Blendex® 491 binder

d) 4.68 parts of Elvacite® 2051 binder

e) 7.34 parts of Lucite® 47 KNL binder

f) 4.20 parts of benzophenone

g) 0.27 parts of Michler's ketone

h) 0.20 parts of 3-mercapto-1,2,4-triazole

i) 0.27 parts of Blue chips

j) 0.27 parts of Yellow chips

k) 30.00 parts of filler which represented three classes of fillers and surface treatment. These include silica, silicates and alumina. All three types were tested in the above composition.

i) Microtalc CP-14-35, magnesium silicate (talc) high grade Montana talc with particle size range of <0.04 to 14 μm.

ii) IMSIL® A-108-H, silica with γ-aminopropyltriethoxysilane surface treatment. Particle shape and size distribution is the same as IMSIL® A-108-S.

iii) Hydral 710, particle size <2.0 μm is alumina made by a Bayer process.

The coating solvent was 97/3, CH₂Cl₂/CH₃OH at 44% solids. All the organic ingredients were dissolved first and the filler added last. The filler was dispersed by ball milling. Improved photospeed, solvent resistance, solderability, creep viscosity and thermal shock was observed. Table 2 shows the result of the evaluation.

TABLE 2

| # FILLER | Photospeed[a] (mJ/cm$^2$ SST) | Solder[b] Dip | Solvent[c] Resistance (> 8 min) |
|---|---|---|---|
| 1 Control | 175/8 | + | + |
| 2 Microtalc | 75/7 | + | + |
| 3 IMSIL® A-108-H | 75/6 | + | + |
| 4 Hydrol® 710 | 75/7 | + | + |

TABLE 2 (continued)

| # FILLER | Creep[d] viscosity (10$^6$ poise) | M&IR[e] (10$^{10}$ ohms) | Thermal[f] Shock | Flammability[g] On 0.062" |
|---|---|---|---|---|
| 1 Control | 33.8 | 1.00 | - | + |
| 2 Microtalc | 61.4 | 0.20 | + | + |
| 3 IMSIL® A-108-H | 96.3 | 0.20 | - | + |
| 4 Hydrol® 710 | 77.8 | 0.25 | - | + |

See Test Procedures in Table 1

## CONTROL II

In the following the importance of particle shape, particle size distribution, the process by which the filler is made, (e.g., air floated vs. water washed) surface treatment of the filler (hydrophobic vs. hydrophilic, surface wettability, dispersion stability, etc.) the acid-base nature of the system is demonstrated by the relative performance of the fillers in the composition given in Control Example I A.

a) Mistron Ultramix and Huber HG-90® have platey particles that belong to the same class but differ in the particle size and particle size distribution. The fillers were incorporated in the composition in identical manner. The narrow particle size distribution and the smaller mean particle size of the Huber HG-90® makes its less preferable from performance criteria.

| Functionality | Huber HG-90 | Mistron Ultramix |
|---|---|---|
| Photospeed 75 mJ/cm$^2$ | 6 SST held | 7 SST held |
| Development Rate | 164 sec. | 140 sec. |
| Creep Viscosity | 162x10$^6$ cp | 246x10$^6$ cp |
| Thermal Shock | Fail | Pass |

b) Particle shape is important for determining the degree of reinforcement in thermal shock performance. In the composition given in Control Example I, Mistron Ultramix which has platey particles with particle size distribution between 1.5 to 10 μm. L-207A Novacite® has both particle size distribution between 0.5 to 15 μm. The shape of the particles is a mixture of platelets and clusters. Particles which have a sheet-like structure have excellent reinforcement. Thermal shock tests run according to MIL-P-55110C (-65 to 125°C, 15 min dwell time, 2 mins transition for 100 cycles) showed the formulation containing Mistron Ultramix had superior performance. The coating containing L-207A Novacite® showed visible cracks on metal and epoxy glass surfaces and along circuit lines.

## TEST PROCEDURE-ADSORPTION

The following procedure was used to determine the adsorption of ingredients on the filler.

| | Ingredients | Wt. of Ingredients | Wt. of Ultramix | Wt. of Solvent |
|---|---|---|---|---|
| 1 | Pentaerythritol triacrylate | 2.64 g | 7.50 g | 89.86 g |
| 2 | Trimethylolpropane triacrylate | 2.65 g | 7.50 g | 89.86 g |
| 3 | Hexamethoxymethyl-melamine | 2.20 g | 7.50 g | 90.31 |
| 4 | Benzophenone | 0.70 g | 7.50 g | 91.80 |
| 5 | Michler's ketone | 0.12 g | 7.50 g | 92.48 |
| 6 | Diethylhydroxylamine | 0.02 g | 7.50 g | 92.48 |
| 7 | 3-Mercapto-1,2,4-triazole | 0.03 g | 7.50 g | 92.48 |
| 8 | HVT-45 Green pigment | 0.53 g | 7.50 g | 91.98 |
| 9 | Carboset®525 binder | 7.38 g | 7.50 g | 85.12 |
| 10 | Amphomer® binder | 0.35 g | 7.50 | 92.15 |
| 11 | PVP K-90 binder | 1.06 g | 7.50 | 91.44 |

The samples were ball milled. Abour 30 ml was transferred into centrifuge test tubes. After centrifuging 5 ml was transferred into a 50 ml volumetric flask and diluted to the mark with 92/8 $CH_2Cl_2/CH_3OH$ coating solvent. Control samples were also prepared by taking 10 ml into 100 ml volumetric flask. The samples were qualitatively analyzed by spectroscopic technique to determine the amount of adsorbed ingredient. Carboset®525, PVP K-90 and Amphomer® binders were difficult to separately centrifuging, indicating the adsorption of these ingredients on the filler. Other ingredients which showed some adsorption were HVT-45 green pigment, diethylhydroxylamine and Michler's ketone.

EXAMPLE 2

The following sequence of ingredient addition was adapted in the solution prep to optimize filler wetting and to stabilize the filler dispersion, in contrast to the sequence given in Control Example 1

| | | PARTS BY WEIGHT |
|---|---|---|
| 1. | $CH_2Cl_2$ | 60.72 |
| 2. | $CH_3OH$ | 5.28 |
| 3. | Carboset®525 | 10.03 |
| 4. | Filler (Cyprubond) | 10.20 |
| 5. | PVP K-90 | 1.43 |
| 6. | Amphomer® | 0.48 |
| 7. | HVT-45 green pigment | 0.71 |
| 8. | Michler's ketone | 0.02 |
| 9. | Diethylhydroxylamine | 0.01 |
| 10. | Pentaerythritol triacrylate | 3.75 |
| 11. | Trimethylolpropane triacrylate | 3.75 |
| 12. | Hexamethoxymethyl melamine | 3.12 |
| 13. | 3-Mercapto-1,2,4-triazole | 0.05 |
| 14. | Benzophenone | 1.00 |

Coatings made using this solution preparation procedure showed better thermal shock performance and improved flame resistance (V-O rating on 0.31" FR-4 glass epoxy) than Control Example 1.

EXAMPLE 3

The following solutions, containing Mistron Vapor talc with 0. 0.5, 1.0, 1.5 and 2.0% surface treatment with γ-aminopropyltrimethoxysilane were prepared. MVTALCOAT™ is NYCO's experimental talc filler (Mistron Vapor) surface treated with the same aminosilane as in Mistron Cyprubond talc. The level of treatment is given in parenthesis below.

| Solution | A | B | C | D | E |
|----------|---|---|---|---|---|
| **Ingredients** | | | | | |
| $CH_3OH$ | 6.00 g | 6.00 g | 6.00 g | 6.00 g | 6.00 g |
| $CH_2Cl_2$ | 69.00 g | 69.00 g | 69.00 g | 69.00 g | 69.00 g |
| Carboset®525 | 7.38 g | 7.38 g | 7.38 g | 7.38 | 7.38 g |
| Mistron Vapor | – | – | – | – | 7.50 g |
| MVTALCOAT 1100-2 (0.5%) | 7.50 g | – | – | – | – |
| MVTALCOAT 1100-4 (0.1%) | – | 7.50 g | – | – | – |
| MVTALCOAT 1100-6 (1.5%) | – | – | 7.50 g | – | – |
| MVTALCOAT 1100-8 (2.0%) | – | – | – | 7.50 g | – |

About 50 ml from each solution was transferred into a centrifuge test tube to determine dispersion stability and solution homogeneity. The untreated talc Mistron Vapor showed settling but no separation in the liquid phase. The surface treated sample showed settling as well as phase separation of the liquid. Solutions A and B showed settling (sedimentation) after 24 hours. Solutions C and D showed only settling. The degree of phase separation is a function of the surface treatment level. The higher the treatment level the less the phase separation. At 1.5% treatment the stability of the dispersion is optimum and phase separation is minimum. On the other hand the level of treatment affects the rate or amount of filler sedimentation in the opposite direction. Higher level of treatment increases sedimentation. Both processes are controlled by viscosity. At 34% solids and 1.0% filler treatment the settling and phase separation were eliminated. Coatings as in Example 2 prepared using this condition showed excellent solder mask functionality performance in thermal shock and flame resistance and manufacturing process. This was demonstrated by the stability and the quality of the dispersion, the solution filter-ability, the better coating and drying conditions achieved in the pilot coating and scale-up.

EXAMPLE 4

The following example shows improved flame retardance was achieved when filler-binder pre-association was optimized. Ingredients were added in the order indicated in Example 2.

| Ingredients | Control Solution | Filled Solution |
|---|---|---|
| $CH_3OH$ | 6.00 | 5.33 |
| $CH_2Cl_2$ | 69.00 | 61.33 |
| Carboset®525 binder | 15.83 | 9.84 |
| Mistron Cyprubond | -- | 10.00 |
| PVP K-90 | 2.25 | 1.40 |
| Amphomer® binder | 0.75 | 0.47 |
| HVT-45 | 1.11 | 0.69 |
| Michler's ketone | 0.04 | 0.03 |
| Diethylhydroxylamine | 0.02 | 0.01 |
| PETA | 5.63 | 3.49 |
| TMPTA | 5.63 | 3.49 |
| Cymel®303 | 4.70 | 2.92 |
| 3-Mercapto-1,2,4-triazole | 0.06 | 0.04 |
| Benzophenone | 1.50 | 0.93 |

These coatings were laminated on 0.031 inch FR-4 laminate. Burn tests according to UL-94 flammability test procedure gave the following results.

| | Examples | Burn Test | UL-94 Rating |
|---|---|---|---|
| 1 | Control | 189 sec | No rating |
| 2 | Mistron Cyprubond filled | 45 sec | V-O |

## EXAMPLE 5

A comparison of melt blending and ball or sand milling was undertaken. The following coatings were prepared by both processes and tests were run on thermal shock performance.

| Ingredients | Ball Milled Composition | Melt Blended Composition |
|---|---|---|
| $CH_2Cl_2$ | 60.72 | 60.72 |
| $CH_3OH$ | 6.00 | 5.33 |
| EP-2600* (Ethylmethacrylate/-methacrylic acid terpolymer) | 10.75 | 10.75* |
| Mistron Cyprubond* | 10.20 | 10.20* |
| PVP K-90 | 0.71 | 0.71 |
| Amphomer® binder | 0.48 | 0.48 |
| HVT-45 green pigment | 0.71 | 0.71 |
| Michler's ketone | 0.02 | 0.02 |
| Diethylhydroxylamine | 0.01 | 0.01 |
| PETA | 1.79 | 1.79 |
| TMPTA | 1.79 | 1.79 |
| TDMA (Triethylene Glycol Dimethacrylate) | 3.57 | 3.57 |
| Cymel®303 | 2.98 | 2.98 |
| 3-Mercapto-1,2,4-triazole | 0.05 | 0.05 |
| Benzophenone | 0.95 | 0.95 |

*EP-2600 and Mistron Cyprubond were melt blended in a twin hot roll mill and high shear dispersed at 150°C.

The ball milled composition was prepared in the order given above by ball milling procedure. EP-2600 and Mistron Cyprubond were melt blended in a twin hot roll mill and the filler dispersed at a high shear in the melt. The melt was cut into smaller pieces and cooled in dry ice. After cooling it was ground into chips using 1/8" screen. In solution preparation the chips were dissolved in the coating solvent and the other ingredients added as in the sequence given above. The thermal shock performance of both compositions were tested. The result is given below.

## Thermal Shock Test Results

| Sample | Visual | 10X |
|--------|--------|-----|
| Ball Milled Composition | no cracks | cracks[a] |
| Melt Blended Composition | no cracks | no cracks |

a - cracks at corners of open square pads on test boards

### EXAMPLE 6

The sequence of ingredient addition with filler-binder pre-association is important. The example below compares the effect of different addition sequence (in the order given) in preparing the coating solution.

### Composition A

| Ingredients | PPH |
|-------------|-----|
| $CH_2Cl_2$ | 60.96 |
| $CH_3OH$ | 5.30 |
| Carboset®525 binder | 5.38 |
| EP-2600 | 5.38 |
| Mistron Cyprubond | 10.24 |
| PVP K-90 | 0.72 |
| Amphomer® binder | 0.51 |
| HVT-45 | 0.72 |
| Michler's ketone | 0.02 |
| Diethylhydroxylamine | 0.01 |
| PETA | 3.38 |
| TMPTA | 3.38 |
| Cymel®303 | 2.99 |
| 3-Mercapto-1,2,4-triazole | 0.05 |
| Benzophenone | 0.96 |

## Composition B

| Ingredients | PPH |
|---|---|
| $CH_2Cl_2$ | 60.96 |
| $CH_3OH$ | 5.30 |
| Carboset®525 binder | 5.38 |
| EP-2600 | 5.38 |
| PVP K-90 | 0.72 |
| Amphomer® binder | 0.51 |
| PETA | 3.38 |
| TMPTA | 3.38 |
| Mistron Cyprubond | 10.24 |
| HVT-45 | 0.72 |
| Michler's ketone | 0.02 |
| Diethylhydroxylamine | 0.01 |
| Cymel®303 | 2.99 |
| 3-Mercapto-1,2,4-triazole | 0.05 |
| Benzophenone | 0.96 |

## 0 259 812

<u>Composition C</u>

| <u>Ingredients</u> | <u>PPH</u> |
|---|---|
| $CH_2Cl_2$ | 69.00 |
| $CH_3OH$ | 6.00 |
| Carboset®525 binder | 5.63 |
| EP-2600 | 5.63 |
| PVP K-90 | 0.75 |
| Amphomer® binder | 0.53 |
| HVT-45 | 0.75 |
| Michler's ketone | 0.02 |
| Diethylhydroxylamine | 0.01 |
| PETA | 3.75 |
| TMPTA | 3.75 |
| Cymel®303 | 3.13 |
| 3-Mercapto-1,2,4-triazole | 0.05 |
| Benzophenone | 1.09 |

The thermal shock performance of these coatings according to MIL-P-55110C condition is summarized below:

<u>Thermal Shock Results</u>

| <u>Samples</u> | <u>Cure Condition</u> | <u>Visual</u> | <u>10x</u> |
|---|---|---|---|
| Composition A | Bake/6J/cm$^2$UV<br>2J/cm$^2$UV/Bake/<br>6J/cm$^2$UV | Pass<br>Pass | Pass[a]<br>Pass[a] |
| Composition B | Bake/6J/cm$^2$UV<br>2J/cm$^2$UV/Bake/<br>6J/cm$^2$UV | Fail<br>Fail | |
| Composition C | Bake/6J/cm$^2$UV<br>2J/cm$^2$UV/Bake/<br>6J/cm$^2$UV | Fail<br>Fail | |

a – slight cracks at corners of open square pads on test boards

Bake is 1 hour at 300°F

## Claims

1. A photopolymerizable composition comprising

(A) an addition polymerizable ethylenically unsaturated monomer,

(B) an initiating system activated by actinic radiation,

(C) at least one preformed macromolecular polymeric binder and

(D) particles of an inorganic material substantially transparent to actinic radiation wherein the particles of inorganic material are associated with at least one of the preformed macromolecular polymeric binders which association is determined by the inability of the inorganic particles to substantially separate from at least one of the binders in solvent for the binder present in the composition.

2. The composition of claim 2 wherein substantially none of the particles will separate from at least one binder in the solvent.

3. The composition of claim 1 wherein 95% of the particles are in the range from 0.1 $\mu$m to 15 $\mu$m.

4. The composition of claim 3 wherein 95% of the particles are in the range from 0.1 $\mu$m to 10 $\mu$m.

5. The composition of claim 3 wherein 97% of the particles are present in said range.

6. The composition of claim 4 wherein 97% of the particles are present in said range.

7. The particles of claim 1 wherein the particles are silica or silicate derivative.

8. A photopolymerizable composition comprising components of:

(A) an addition polymerizable ethylenically unsaturated monomer,

(B) an initiating system activated by actinic radiation,

(C) at least one preformed macromolecular polymeric binder and

(D) particles of an inorganic material substantially transparent to actinic radiation wherein the particles of inorganic material are associated with at least one of the preformed macromolecular polymeric binders prior to the addition of the othr composition ingredients which association is determined by the inability of the inorganic particles to substantially separate from at least one of the binders in solvent for the binder, in comparison to an identical photopolymerizable composition except its components are premixed simultaneously with its inorganic particles separating from the binder in the solvent.

9. A process of forming a photopolymerizable composition comprising

(A) an addition polymerizable ethylenically unsaturated monomer,

(B) an initiating system activated by actinic radiation,

(C) at least one preformed macromolecular polymeric binder and

(D) particles of an inorganic material substantially transparent to actinic radiation wherein components (C) and (D) are initially mixed in the substantial absence of components (A) and (B).

10. The process of claim 9 wherein one preformed macromolecular polymeric binder is present.

11. The process of claim 9 wherein more than one polymeric binder is present and the association of polymeric binder and inorganic particulate materials is in the absence of at least one of the polymeric binders.

12. A process for forming a solder mask on a substrate comprising

(a) laminating to the substrate a layer of a supported photopolymerizable film,

(b) imagewise exposing the layer to actinic radiation,

(c) removing unexposed areas of the layer,

(d) applying molten solder which adheres to the substrate in areas which are not protected by the exposed film wherein the film is formed from a photopolymerizable composition comprising:

(A) an addition polymerizable ethylenically unsaturated monomer,

(B) an initiating system activated by actinic radiation,

(C) at least one preformed macromolecular polymeric binder and

(D) particles of an inorganic material substantially transparent to actinic radiation wherein the particles of inorganic material are associated with at least one of the preformed macromolecular polymeric binders which association is determined by the inability of the inorganic particles to substantially separate from at least one of the binders in solvent for the binder.

13. The process of claim 12 wherein the association is by melt blending.

14. The process of claim 12 wherein the association is by high shear dispersion.

15. The process of claim 12 wherein the particles are surface modified prior to association.